# EUROPÄISCHE PATENTSCHRIFT

(11) **EP 1 434 349 B1**
(45) Veröffentlichungstag und Bekanntmachung des Hinweises auf die Patenterteilung: **26.01.2005**
(21) Anmeldenummer: 03027135.7
(22) Anmeldetag: 26.11.2003
(51) Int. Cl.: H03K 17/082

(54) **Schaltungsordnung zum Schutz eines Transistors gegen Überstrom und Überspannung**
Circuit for protecting a transistor against overvoltage and overcurrent
Circuit de protection d'un transistor contre la surtension et la surintensité de courant

(30) Priorität: 30.11.2002 DE 10256057
(43) Veröffentlichungstag der Anmeldung: 30.06.2004
(73) Patentinhaber: Semikron Elektronik GmbH, 90431 Nürnberg (DE)
(72) Erfinder: Nascimento, Jair do, 91077 Dormitz (DE); Mühlhöfer, Alexander, 90439 Nürnberg (DE)

(56) Entgegenhaltungen:
- DE-A- 3 238 899
- DE-C- 3 121 754
- US-A- 4 503 480
- US-A- 4 849 683

## Beschreibung

Die Erfindung beschreibt eine Schaltungsanordnung zum Schutz eines Transistors gegen Überspannung und / oder Überstrom um eine thermische Zerstörung des Transistors zu vermeiden.

Transistoren, speziell einer Nennleistung von unter 10W und für Spannungen unter 60V, weisen nach dem Stand der Technik keine integrierte Schutzbeschaltung gegen an ihrem Eingang angelegte Spannung mit einem Spannungswert über dem für diesen Transistor zulässigen oder gegen einen Stromfluss zwischen Eingang und Ausgang über dem für den Transistor zulässigen auf. Beispielhaft wird im weiteren ein npn- Bipolartransistor betrachtet, wobei der Eingang der Kollektor, der Ausgang der Emitter und der Steuereingang die Basis ist.

Den Stand der Technik bilden Transistoren höherer Nennleistung mit im Gehäuse integrierten Schutzschaltungen wie beispielsweise die HITFET® - Reihe von Infineon. Hierin sind Schutzbeschaltungen gegen Überspannung oder zur Strombegrenzung integriert.

Ausgangspunkt dieser Erfindung sind Schaltungsanordnungen (Treiber) beispielhaft in der DE 101 10 100 A1 beschrieben zur Ansteuerung von Leistungshalbleitermodulen. Derartige Schaltungsanordnungen weisen Schnittstellen zur Fehlermeldung an übergeordnete Steuereinheiten auf. Nach dem Stand der Technik, wie er beispielhaft dargelegt ist in U. Nicolai et al., "Applikationshandbuch IGBT- und MOSFET- Leistungsmodule", ISBN 3-932633-24-5, Seite 190 bis 196, werden derartige Schnittstellen zur Fehlerübertragung mittels eines Transistors in "Open- Kollektor-" Beschaltung realisiert. Hierbei wird der Steuereingang des Transistors mit einer Steuerspannung beaufschlagt, der Eingang, Kollektor, des Transistors bildet die Schnittstelle und der Ausgang, Emitter, ist mit dem Grundpotential verbunden. Die Schnittstelle ist über einen Widerstand, der in der Ansteuerschaltung lokalisiert ist mit einer Spannungsquelle innerhalb dieser verbunden. Zur Überwachung des Fehlersignals des Treibers wird von der Ansteuerung die Spannung am Eingang dieses Transistors bestimmt. Mit dieser Schaltungsanordnung ist nicht nur eine Detektion eines Fehlersignals, sondern auch eine Überwachung der Verbindungsleitung auf Leitungsunterbrechung implementiert.

Falls die Steuerspannung einen HIGH- Pegel aufweist, ist der Transistor leitend geschalten, wobei am, in der Ansteuerschaltung lokalisiertem, Widerstand bzw. am Eingang des Transistors nahezu Grundpotential anliegt und dies von der Ansteuerschaltung als "fehlerfrei" bewertet wird.

Falls diese Steuerspannung einen LOW- Pegel aufweist, ist der Transistor nicht leitend geschaltet, wobei am Eingang des Transistors bzw. am, in der Ansteuerschaltung lokalisierten, Widerstand nahezu die Spannung der ebenfalls innerhalb der Ansteuerschaltung lokalisierten Spannungsquelle anliegt. Dies wird als "fehlerbehaftet" von der Ansteuerschaltung bewertet. Dieser Fehler tritt ebenso auf, falls eine Leitungsunterbrechung in der Verbindungsleitung vorliegt.

Nachteilig an diesem Stand der Technik ist, dass der Transistor durch eine zu hohe Spannung an seinem Eingang bzw. durch einen zu hohen Durchgangsstrom und damit einer zu hohen Verlustleistung zerstört werden kann und somit ein Teil der Funktionalität der Treiberschaltung nicht mehr gegeben ist. Ein Überstrom kann beispielhaft entstehen, falls der in der Ansteuerschaltung lokalisierte Widerstand zu klein ist oder falls der Ausgang der Treiberschaltung mit einer Spannungsquelle direkt verbunden wird.

Schaltungsanordnungen zum Schutz eines Transistors gegen Überlastung sind aus den Dokumenten US-A-4 503 480 und US-A-4 849 683 bekannt.

Die vorliegende Erfindung hat die Aufgabe, eine Schaltungsanordnung zum Schutz eines Transistors gegen eine zu hohe Spannung an seinem Eingang und / oder gegen einen zu hohen Durchgangsstrom zwischen Eingang und Ausgang unter Verwendung einer geringen Zahl von Bauelementen vorzustellen.

Die Aufgabe wird gelöst durch die Maßnahmen des Anspruchs 1.

Der Grundgedanke der Erfindung liegt darin eine Schaltungsanordnung vorzustellen, die den Transistor schützt, indem ein Durchschalten bei zu hoher Spannung am Eingang verhindert wird und indem der Durchgangsstrom durch den Transistor auf einen geeigneten Wert begrenzt wird. Hierzu weist die Schaltung mindestens folgende Merkmale auf:

Der Steuereingang des zu schützenden Transistors ist mit dem Open- Kollektor-Ausgang eines Komparators verbunden sowie über einen Widerstand mit einer Versorgungsspannungsquelle und über einen Kondensator mit Massepotential. Der nichtinvertierende Schwellwerteingang des Komparators ist mit der Anzapfung einer Spannungsteilerschaltung zwischen einer Steuerspannung und dem Massepotential verbunden. Der invertierende Schwellwerteingang des Komparators ist mit der Anzapfung einer Spannungsteilerschaltung verbunden, deren erster Spannungsteilerwiderstand mit der Versorgungsspannungsquelle verbunden ist und deren zweiter Spannungsteilerwiderstand mit dem Emitter des Transistors verbunden ist. Der invertierende Schwellwerteingang des Komparators ist über einen Widerstand mit dem Kollektor des Transistors verbunden. Der Emitter des Transistors ist über einen Widerstand mit dem Massepotential verbunden.
- Fig. 1: zeigt eine Schaltungsanordnung nach dem Stand der Technik.
- Fig. 2: zeigt eine Ausgestaltung der erfinderischen Schaltungsanordnung.

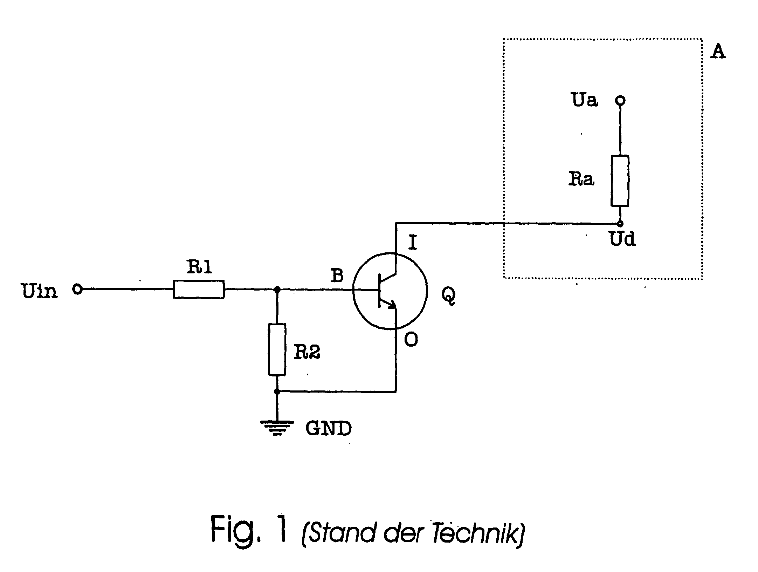

Fig. 1 zeigt eine Schaltungsanordnung nach dem Stand der Technik. Hierbei ist der Steuereingang des Transistors (Q) über einen Spannungsteiler (R1, R2) zwischen der Steuerspannung (Uin) und dem Grundpotential (GND) verbunden. Der Ausgang (O), der Emitter, des Transistors (Q) ist mit dem Grundpotential (GND) verbunden. Der Eingang (I), der Kollektor, des Transistors (Q) bildet die Schnittstelle zu einer Ansteuereinheit (A) mit deren Spannungsquelle (Ua) er über den Widerstand (Ra) verbunden ist. Liegt die Steuerspannung (Uin) auf HIGH- Pegel, ist der Transistor (Q) durchgeschaltet und am Widerstand (Ra) liegt Grundpotential an. Die Steuereinheit wertet dies als fehlerfreie Funktion des Treibers aus. Liegt die Steuerspannung (Uin) auf LOW- Pegel, ist der Transistor (Q) gesperrt und an dessen Ausgang (I) bzw. am Widerstand (Ra) liegt das Potential (Ud) der Spannungsquelle (Ua) an. Dies wertet die Ansteuereinheit als fehlerbehaftetes Signal. Dieser Fehler kann einerseits einen Fehler des Treibers beschrieben durch einen LOW- Pegel der Steuerspannung (Uin) oder einen Kabeldefekt des Verbindungskabels zwischen dem Eingang (I) des Transistors (Q) und dem Widerstand (Ra) der Ansteuereinheit bedeuten.

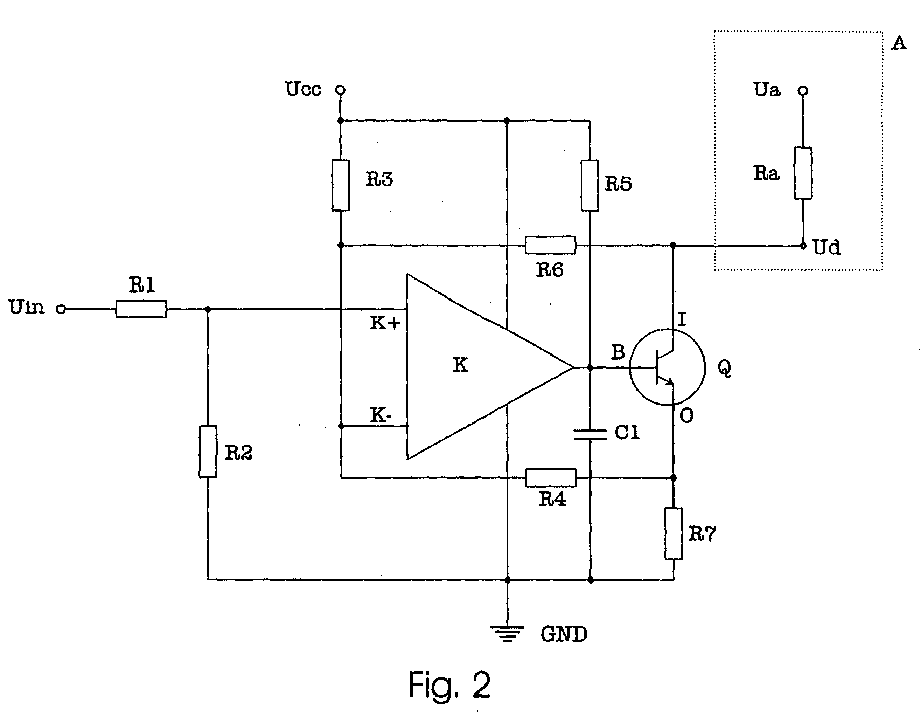

Fig. 2 zeigt eine Ausgestaltung der erfinderischen Schaltungsanordnung. Zur Dimensionierung der Schaltung sei auf folgende Tabelle verwiesen:

| | |
|---|---|
| R1 | 3,32 kΩ |
| R2 | 301 Ω |
| R3 | 100 kΩ |
| R4 | 1 kΩ |
| R5 | 51 kΩ |
| R6 | 121 kΩ |
| Ra | 1 kΩ bis 12 kΩ |
| Re | 10 Ω |
| C1 | 470 pF |
| Uin | 0V / 5 V |
| Ucc | 15 V |
| Ua | 5 V bis 30 V |
| K | LM 2901 |

Die Funktionen der Schaltung bei verschiedenen Parametem werden im Weiteren erläutert.

Funktionsbeschreibung unter folgenden Annahmen: Die Spannung (Ua) der Ansteuerschaltung (A) liegt innerhalb der Toleranzen, der Widerstand (Ra) liegt ebenfalls innerhalb der Toleranzen, die Steuerspannung (Uin) liegt auf HIGH- Pegel, signalisiert also fehlerfreien Betrieb des Treibers.

Unter diesen Voraussetzungen ist die Spannung am oberen Steuereingang (K+ ≈ 400mV), gebildet mittels des Spannungsteilers bestehend aus den Widerständen (R1, R2), des Komparators (K) größer als diejenige am unteren Steuereingang (K- ≈ 150mV). Somit ist der Ausgang des Komparators spannungslos. Der Steuereingang (B) des Transistors (Q) wird über den Widerstand (R5) von der Spannungsquelle (Vcc) mit Strom versorgt, der Transistor ist durchgeschaltet. Somit ist die Spannung am Punkt (Ud ≈ 300mV) annährend gleich dem Grundpotential, da der Spannungsabfall über dem Widerstand (R7) und dem Innenwiderstand des Transistors (Q) sehr gering ist verglichen zum Spannungsabfall über dem Widerstand (Ra).

Funktionsbeschreibung unter folgenden Annahmen: Die Spannung (Ua) der Ansteuerschaltung (A) liegt innerhalb der Toleranzen, der Widerstand (Ra) liegt ebenfalls innerhalb der Toleranzen, die Steuerspannung (Uin) liegt auf LOW- Pegel, signalisiert also fehlerbehafteten Betrieb des Treibers.

Unter diesen Voraussetzungen ist die Spannung am oberen Steuereingang (K+ ≈ 0V) des Komparators (K) kleiner als diejenige am unteren Steuereingang (K- > 150mV) gespeist aus der Spannungsquelle (Ucc) über den Widerstand (R3), um hier einen undefinierten Zustand, mit (K- ≈ 0V) zu vermeiden. Somit liegt der Ausgang des Komparators (K) auf Grundpotential und dadurch liegt der Steuereingang (B) des Transistors (Q) ebenfalls auf Grundpotential, der Transistor ist somit nicht leitend. Damit ist die Spannung am Punkt (Ud ≈ Ua) annährend gleich der Spannung der Spannungsquelle (Ua).

Funktionsbeschreibung unter folgenden Annahmen: Die Spannung am Eingang (I) des Transistors (Q) liegt oberhalb des Maximalwertes, die Steuerspannung (Uin) liegt auf HIGH-Pegel, signalisiert also fehlerfreien Betrieb des Treibers.

Das Potential am unteren Steuereingang (K-) des Komparators (K) ist über die Widerstände (R6, Ra) mit der Spannungsquelle (Ua) verbunden. Ist nun die Spannung am Eingang des Transistors (Q) zu hoch, steigt auch die Spannung an dem unteren Steuereingang (K-) des Komparators (K). Sobald der Spannungswert am unteren Steuereingang einen Wert größer desjenigen am oberen Steuereingang (K- > K+) erreicht kippt der Komparator und der Ausgang liegt auf Grundpotential. Dadurch liegt auch der Steuereingang (B) des Transistors (Q) ebenfalls auf Grundpotential und der Transistor ist nichtleitend und somit vor Zerstörung geschützt.

Funktionsbeschreibung unter folgenden Annahmen: Der Durchgangsstrom durch den Transistors (Q) steigt über den Maximalwert, beispielhaft durch einen zu klein dimensionierten Widerstand (Ra), die Steuerspannung (Uin) liegt auf HIGH- Pegel, signalisiert also fehlerfreien Betrieb des Treibers.

Bei steigendem Strom durch den Transistor (Q) steigt die Spannung am unteren Steuereingang (K-) des Komparators (K). Somit erreicht auch hier der untere Steuereingang einen höheren Spannungswert als der obere Steuereingang (K- > K+). Dadurch kippt der Komparator und der Ausgang des Komparators (K) sowie der Steuereingang (B) des Transistors (Q) liegen auf Grundpotential, somit ist der Transistor nicht leitend. Durch das Ausschalten des Transistors (Q) sinkt der Spannungswert am unteren Steuereingang (K-) des Komparators wieder, der Komparator kippt erneut und der Transistor wird nach oben beschriebenen Mechanismus wieder durchgeschaltet. Es stellt sich ein zyklischer Wechsel zwischen den beiden Schaltzuständen des Transistor ein, dessen Tastverhältnis durch den Kondensator (C1) beeinflusst ist. Somit wird der Transistor (Q) wirksam vor einem zu hohen Durchgangsstrom geschützt.

## Patentansprüche

1. Schaltungsanordnung zum Schutz eines Transistors (Q) gegen Überlastung, wobei
der Steuereingang (B) des Transistors mit dem Open- Kollektor- Ausgang eines Komparators (K), über einen Widerstand (R5) mit einer Versorgungsspannungsquelle (Ucc) und über einen Kondensator (C1) mit Massepotential (GND) verbunden ist,
der nichtinvertierende Schwellwerteingang (K+) des Komparators (K) mit der Anzapfung einer Spannungsteilerschaltung (R1, R2) zwischen einer Steuerspannung (Uin) und dem Massepotential (GND) verbunden ist,
der invertierende Schwellwerteingang (K-) des Komparators (K) mit der Anzapfung einer Spannungsteilerschaltung (R3, R4) verbunden ist, deren erster Spannungsteilerwiderstand (R3) mit der Versorgungsspannungsquelle (Ucc) verbunden ist und deren zweiter Spannungsteilerwiderstand (R4) mit dem Emitter (O) des Transistors (Q) verbunden ist, und wobei weiterhin
der invertierende Schwellwerteingang (K-) des Komparators (K) über einen Widerstand (R6) mit dem Kollektor (I) des Transistors (Q) verbunden, und der Emitter (O) des Transistors (Q) über einen Widerstand (R7) mit dem Massepotential (GND) verbunden ist.

## Claims

1. A circuit arrangement for the protection of a transistor against overload, wherein
- the control input (B) of the transistor is connected to the open-collector output of a comparator (K) via a resistor (R5) to a supply voltage source (Ucc) and via a capacitor (C1) to mass potential (GND),
- the non-inverting threshold value input (K+) of the comparator (K) is connected to the tap of a voltage divider circuit (R1, R2) between a control voltage (Uin) and mass potential (GND),
- the inverting threshold value input (K-) of the comparator (K) is connected to the tap of a voltage divider circuit (R3, R4), the first voltage divider resistor (R3) of which is connected to the supply voltage source (Ucc) and the second voltage divider resistor (R4) of which is connected to the emitter (O) of the transistor (Q), and wherein further
- the inverting threshold value input (K-) of the comparator (K) is connected to the collector (I) of the transistor (Q) via a resistor (R6), and the emitter (O) of the transistor (Q) is connected to mass potential (GND) via a resistor (R7).

## Revendications

1. Circuit pour la protection d'un transistor (Q) contre une surcharge, tel que
l'entrée de commande (B) du transistor est reliée à la sortie en collecteur ouvert d'un comparateur (K) par l'intermédiaire d'une résistance (R5) à une source de tension d'alimentation (Ucc) et par l'intermédiaire d'un condensateur (C1) au potentiel de masse (GND),
l'entrée à valeur de seuil non inversée (K +) du comparateur (K) est reliée à la prise d'un circuit diviseur de tension (R1, R2) entre une tension de commande (Uin) et le potentiel de masse (GND),
l'entrée à valeur de seuil inversée (K -) du comparateur (K) est reliée à la prise d'un circuit diviseur de tension (R3, R4) dont la première résistance de diviseur de tension (R3) est reliée à la source de tension d'alimentation (Ucc) et dont la deuxième résistance de diviseur de tension (R4) est reliée à l'émetteur (O) du transistor (Q), et
l'entrée à valeur de seuil inversée (K -) du comparateur (K) est reliée par l'intermédiaire d'une résistance (R6) au collecteur (I) du transistor (Q) et l'émetteur (O) du transistor (Q) est relié par l'intermédiaire d'une résistance (R7) au potentiel de masse (GND).
